# FASCICULE DE BREVET EUROPEEN

(11) **EP 0 827 204 B1**
(45) Date de publication et mention de la délivrance du brevet: **03.05.2006**
(21) Numéro de dépôt: 97410093.5
(22) Date de dépôt: 26.08.1997
(51) Int. Cl.: H01L 27/08

(54) **Pont redresseur protégé monolithique**
Geschützte monolithische Gleichrichteranordnung
Protected monolithic rectifier bridge

(30) Priorité: 27.08.1996 FR 9610659
(43) Date de publication de la demande: 04.03.1998
(73) Titulaire: STMicroelectronics S.A., 92120 Montrouge (FR)
(72) Inventeur: Ballon, Christian, 37000 Tours (FR); Bernier, Eric, 37390 Mettray (FR)
(74) Mandataire: de Beaumont, Michel

(56) Documents cités:
- EP-A- 0 655 784
- EP-A- 0 721 218
- PATENT ABSTRACTS OF JAPAN vol. 011, no. 359 (E-559), 21 novembre 1987 (1987-11-21) & JP 62 134962 A (NEC CORP), 18 juin 1987 (1987-06-18)

## Description

La présente invention concerne la réalisation d'un pont redresseur monolithique protégé vis-à-vis de surtensions.

Les composants de puissance couramment disponibles sur le marché sont réalisés à partir de technologies dans lesquelles la face arrière du composant est uniformément revêtue d'une métallisation en contact avec les couches semiconductrices apparentes de cette face arrière. Avec des technologies de ce type, il a été considéré jusqu'à présent qu'il n'était pas possible de réaliser sous forme monolithique un composant assurant les fonctions d'un pont redresseur de moyenne ou forte puissance protégé contre des surtensions, et de tels composants ne sont pas disponibles sur le marché.

Par ailleurs, la demande de brevet français FR-A-2 729 008, correspondant à la demande de brevet européenne EP-A-0 721 218, intitulée "circuit intégré de puissance", décrit une nouvelle conception de circuit intégré de puissance qui permet d'assembler de nombreux composants logiques et de puissance de façon monolithique dans un même composant semiconducteur. Pour arriver à ce résultat, cette demande de brevet enseigne notamment d'utiliser de façon appropriée des couches isolantes formées sur la face arrière d'un composant, la métallisation de face arrière étant pour partie en contact avec les structures semiconductrices de face arrière et en étant pour partie isolée par ces couches isolantes.

L'utilisation des enseignements de cette demande de brevet est extrêmement riche et permet de réaliser sous forme monolithique de nombreux assemblages de composants qui n'étaient antérieurement réalisés que sous forme d'assemblages de composants discrets.

Parmi les exemples d'application donnés dans cette demande de brevet, figurent des ponts redresseurs protégés contre des surtensions.

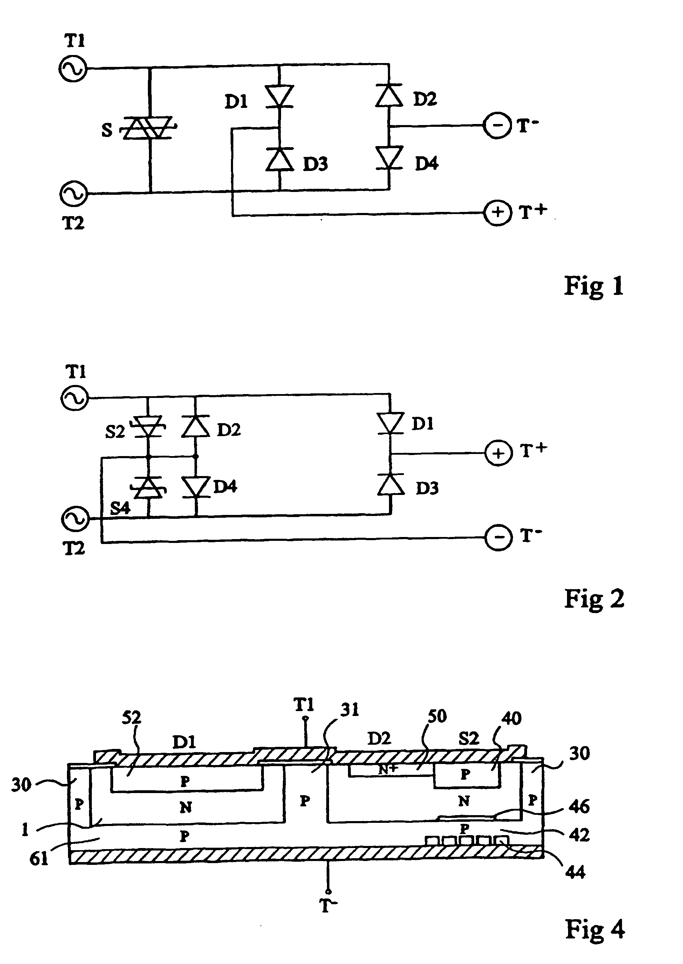

La figure 11A de cette demande de brevet antérieure, reprise dans la figure 1 ci-jointe représente un tel pont redresseur protégé comprenant quatre diodes de redressement D1 à D4 et une double de Shockley S. Des schémas équivalents au schéma de la figure 11A de cette demande de brevet sont illustrés dans les figures 11B et 11C, cette dernière figure étant reprise dans la figure 2 ci-jointe. On notera que d'un point de vue fonctionnel, le schéma de la figure 2 est strictement identique à celui de la figure 1. Dans les figures 1 et 2, les bornes T1, T2 désignent des bornes d'alimentation alternatives et les bornes T+ et T-désignent des bornes de fourniture de tension continue.

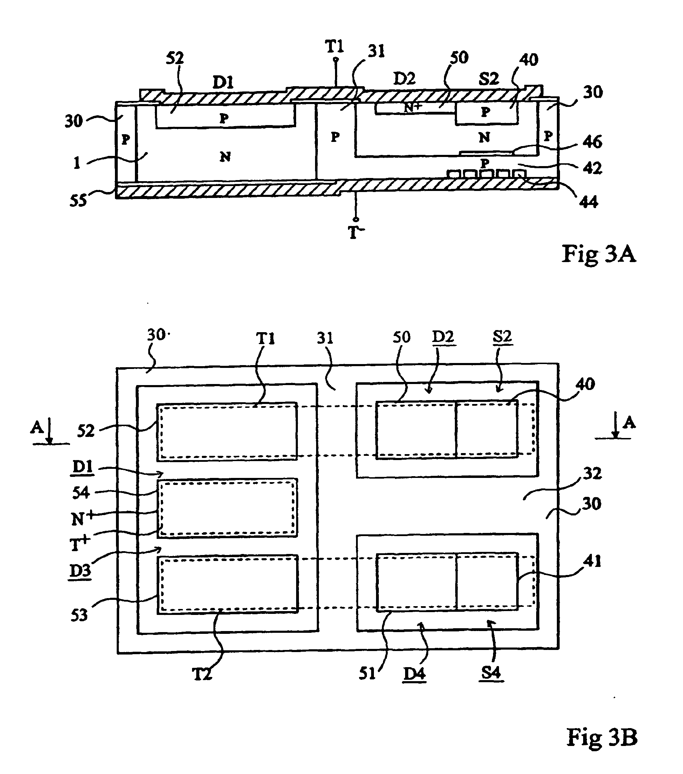

Ensuite, cette demande de brevet antérieure représente dans ses figures 13A et 13B, reprises dans les figures 3A et 3B ci-jointes, un exemple schématique de réalisation du circuit illustré en figure 11C (figure 2 ci-jointe). Dans les figures 3A et 3B, on a gardé exactement les mêmes références numériques que dans les figures 13A et 13B de la demande de brevet antérieure et, pour la description de ces figures, on se référera à cette demande de brevet antérieure.

On rappellera seulement que :
le substrat 1, de type N, est faiblement dopé,
les régions 30 et 31 correspondent à des murs d' isolement de type P,
la diode D2 et la diode de Shockley S2 sont formées verticalement dans un premier caisson,
la diode D4 et la diode de Shockley S4 sont formées verticalement dans un deuxième caisson,
les diodes D1 et D3 sont formées sous forme latérale dans un troisième caisson.

La diode D1 correspond aux régions PNN⁺ 51, 1, 54,
la diode D3 correspond aux régions PNN⁺ 53, 1, 54,
la diode D2 correspond aux régions PNN⁺ 42, 1, 50, et la diode D4 à des régions homologues,
la diode de Shockley S2 comprend de son anode à sa cathode les régions 40, 1, 46, 42 et 44 et la diode de Shockley S4 comprend des régions homologues.

La structure décrite et représentée schématiquement en figures 3A et 3B donne des résultats satisfaisants.

Toutefois, dans le domaine de la fabrication des composants semiconducteurs, les fabricants souhaitent généralement s'écarter aussi peu que possible de filières classiques et éprouvées. Ainsi, quand il est possible d'éviter d'avoir recours à une technologie nécessitant l'utilisation d'une couche isolée en face arrière, ils préfèrent le faire.

Un objet de la présente invention est donc de prévoir une structure de pont redresseur protégé monolithique dans laquelle la métallisation de face arrière est, sur toute son étendue, en contact avec une structure semiconductrice.

Un autre objet de la présente invention est de prévoir une telle structure dans laquelle les propriétés des diverses diodes sont optimisées par un choix approprié des étapes de dopage utilisées.

Un autre objet de la présente invention est de prévoir une telle structure dans laquelle les effets d'éventuels transistors parasites sont rendus négligeables.

Pour atteindre ces objets ainsi que d'autres, la présente invention prévoit une structure semiconductrice selon la revendication 1. Des réalisations particulières sont définies dans les revendications dépendantes.

Ces objets, caractéristiques et avantages, ainsi que d'autres de la présente invention seront exposés plus en détail dans la description suivante de modes de réalisation particuliers faite à titre non limitatif en relation avec les figures jointes parmi lesquelles :
les figures 1 et 2 représentent des schémas de ponts redresseurs protégés contre des surtensions ;
les figures 3A et 3B représentent une vue en coupe et une vue de dessus schématique d'une structure de pont redresseur protégé monolithique selon l'art antérieur ;
la figure 4 représente une vue en coupe schématique d'une structure de pont redresseur protégé monolithique selon la présente invention ; et
les figures 5A et 5B représentent une vue en coupe et une vue de dessus schématique d'une structure de pont redresseur protégé selon la présente invention.

Comme cela est classique dans le domaine de la représentation des composants semiconducteurs, les diverses vues en coupe ne sont pas tracées à l'échelle et sont fortement schématiques pour simplifier la lisibilité et le tracé des figures.

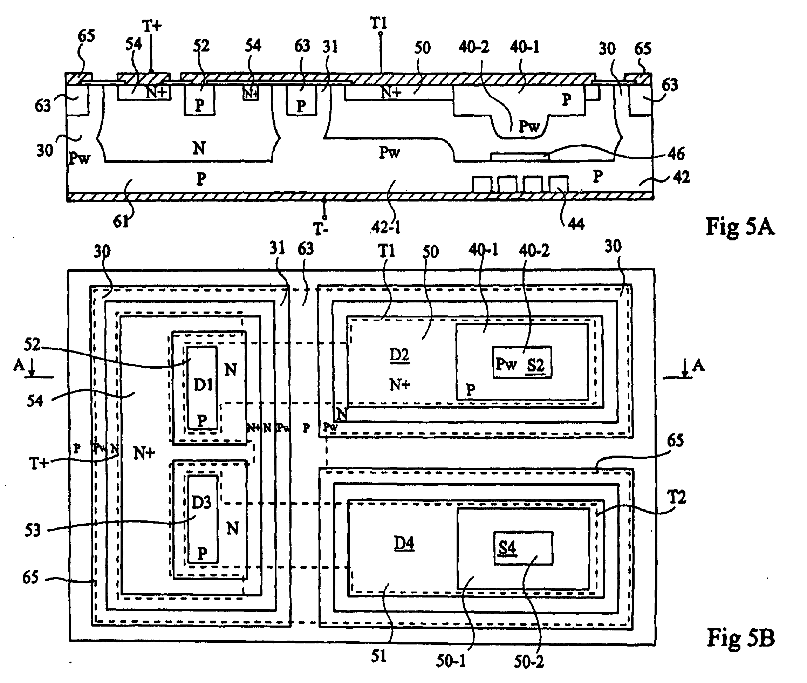

La figure 4 représente de façon extrêmement schématique une vue en coupe d'une structure selon la présente invention, représentée de façon analogue à celle de la figure 3A. Dans ces deux figures, ainsi que dans les figures suivantes, de mêmes références désignent de mêmes éléments.

Selon la présente invention, le caisson contenant les diodes D1 et D3 est modifié. La couche isolante de face arrière 55 est supprimée et une couche de type P 61 est formée du côté de la face arrière.

Il s'avère que dans cette structure, la jonction entre le substrat 1 et la couche 61 est toujours polarisée de façon satisfaisante pour éviter le déclenchement de diodes, transistors ou thyristors parasites.

On notera que le passage d'un isolement diélectrique comme dans le cas de la figure 3A à un isolement par jonction comme dans le cas de la figure 4 était loin de s'imposer à l'homme de métier. En effet, parmi tous les exemples de structures décrits dans la demande de brevet antérieure susmentionnée, seule la structure de la figure 3 peut être transformée pour arriver à cette solution de façon satisfaisante. On rappellera également que, avant la réalisation de la structure décrite en figure 3 et des autres structures décrites dans la demande de brevet antérieure, il n'était pas connu de réaliser sous forme monolithique un pont redresseur protégé en utilisant les techniques classiques d'isolement par jonction et de contact entre une face arrière d'une tranche semiconductrice et une métallisation.

Les figures 5A et 5B illustrent en vue en coupe et en vue de dessus un exemple de réalisation d'une structure selon l'invention. Cette réalisation est faite selon une technologie selon laquelle on utilise, dans un substrat de type N d'un niveau de dopage de 1 à 6.10¹⁴ atomes/cm³, les étapes principales de diffusion suivantes :
- une première diffusion profonde de type P ou P_{caisson} qui s'étend en fin de processus sur une profondeur supérieure à la moitié de l'épaisseur du substrat et ayant par exemple une concentration en surface Cs = 5.10¹⁷ atomes/cm³. Cette diffusion sert notamment à former des murs d'isolement divisant la structure semiconductrice en plusieurs caissons. Dans la figure 5A, ce type de diffusion est désigné à certains emplacements par la référence P_{W},
- une deuxième diffusion de type P moins profonde et plus dopée en surface ayant par exemple une profondeur de diffusion xj = 20 µm et une concentration en surface Cs = 10¹⁸ atomes/cm³. Dans la figure, certaines des régions correspondant à cette deuxième diffusion sont simplement désignées par la lettre P,
- une diffusion de type N fortement dopée, désignée dans la figure par la référence N⁺, et
- éventuellement, une diffusion profonde de type N destinée à fixer le seuil de déclenchement des diodes de Shockley.

Dans les figures 5A et 5B, la diode D2 et la diode de Shockley S2 sont formées dans un premier caisson, la diode D4 et la diode de Shockley S4 sont formées dans un deuxième caisson et les diodes D1, D3 sont formées dans un troisième caisson.

L'allure générale des diodes dans les premier et deuxième caissons correspond à celle illustrée schématiquement en figures 3 et 4. On notera toutefois que la partie de la couche P 42 du côté de la face arrière des diodes D2 et D4, désignée par la référence 42-1, correspond à une diffusion profonde du type désigné précédemment par l'appellation P_{caisson}. L'anode 40 de la diode de Shockley S2 (et l'anode correspondante de la diode de Shockley S4) est constituée d'une partie centrale 40-2 correspondant à la première diffusion P_{W} et d'une partie superficielle plus étendue 40-1 correspondant à la deuxième diffusion de type P.

En ce qui concerne le troisième caisson dans lequel sont formées les diodes D1 et D3, la face arrière est, comme on l'a indiqué précédemment, munie d'une région de type P 61. Cette région est du deuxième type de diffusion P et non pas de type P_{caisson}.

Comme le représente la vue de dessus de la figure 5B, la disposition des couches du côté de la face supérieure du substrat dans le troisième caisson est distincte de celle de la figure 3B. Plus particulièrement, la région 54 de type N constituant la cathode commune des diodes D1 et D3 entoure les régions 52 et 53 de type P constituant les cathodes de ces diodes D1 et D3.

On se reportera à cette figure 5B pour la topologie générale des diverses régions.

Le mode de réalisation décrit comporte de nombreuses optimisations destinées à éviter l'influence de transistors parasites. En particulier :
les transistors parasites PNP verticaux dont les émetteurs correspondent aux anodes 52, 53 des diodes D1 et D3 et dont les collecteurs correspondent à la région 61 ont un gain réduit du fait que leur base correspond au substrat de forte épaisseur et que leurs émetteurs et collecteurs correspondent à des diffusions P peu profondes (et non pas à des diffusions P_{caisson}),
le transistor parasite PNP latéral dont l'émetteur et le collecteur correspondent respectivement à l'anode 52, 53 de chacune des diodes D1 et D3 a un gain réduit par suite d'un éloignement convenable entre ces anodes, et
le transistor parasite NPN latéral dont l'émetteur et le collecteur correspondent respectivement à la cathode 50, 51 de chacune des diodes D2 et D4 a un gain réduit par suite d'un éloignement convenable entre ces cathodes, et du fait que sa base correspond à une région P_{caisson} 42-1, relativement fortement dopée.

On notera en outre qu'à l'intérieur de chacune des régions P_{caisson} formant mur d'isolement, est formée, du côté de la face supérieure, une région de type P 63. La plus grande partie de cette région 63 est revêtue d'une métallisation 65 qui s'étend à l'extérieur du pointillé de même référence de la figure 5B. De préférence, au moins entre les divers caissons, cette région 63 est dédoublée (non représenté) pour améliorer la tenue en tension de l'oxyde recouvrant les régions 30-31-63. En effet, la tenue en tension de l'oxyde est meilleure au-dessus des diffusions P_{W} que sur les région perturbées par la double diffusion P_{W} et P.

## Revendications

1. Structure semiconductrice constituant un pont redresseur protégé réalisé dans un substrat semiconducteur (1) de type N divisé en trois caissons par des murs d'isolement verticaux (30, 31) de type P, dans laquelle la face arrière du substrat est revêtue d'une première métallisation (T-), dans laquelle chacun des premier et deuxième caissons comporte une diode verticale (D2, D4) et une diode de Shockley verticale (S2, S4), la première métallisation étant en contact avec les couches d'anode (42-1) des diodes verticales et les couches de cathode (44) des diodes de Shockley et dans laquelle le troisième caisson comporte, du côté de sa face avant, deux diodes latérales dont chacune est formée entre une région de type P (52, 53) et le substrat,
**caractérisée en ce que** le troisième caisson est séparé de la première métallisation par une couche de type P d'isolement (61) s'étendant du côté de sa face arrière en contact avec la première métallisation.

2. Structure semiconductrice selon la revendication 1, **caractérisée en ce que** les couches d'anode (42-1) du côté de la face arrière des diodes verticales des premier et deuxième caissons sont constituées d'une région diffusée profonde semblable à une diffusion de mur d'isolement.

3. Structure semiconductrice selon l'une des revendications 1 ou 2, **caractérisée en ce que** les couches d'anode (40-1, 40-2) de chacune des diodes de Shockley sont constituées d'une partie centrale (40-2) formée d'une diffusion semblable à une diffusion de mur d'isolement et d'une partie latérale (40-1) constituée d'une diffusion de type P moins profonde et plus dopée en surface.

4. Structure semiconductrice selon l'une quelconque des revendications 1 à 3, **caractérisée en ce que** chacun des murs d'isolement comprend une région surdopée du même type de conductivité (63), revêtue sur la plus grande partie de sa surface d'une métallisation (65).

5. Structure semiconductrice selon la revendication 1, **caractérisée en ce que** les couches d'anode (52, 53) des diodes latérales et ladite couche de type P d'isolement (61) sont des couches peu profondes et fortement dopées.

## Claims

1. A semiconducting structure forming a protected rectifying bridge implemented in an N-type semiconductor substrate (1) divided into three wells by vertical P-type insulating walls (30, 31), in which the rear surface of the substrate is coated with a first metallization (T-) and in which each of the first and second wells includes a vertical diode (D2, D4) and a vertical Shockley diode (S2, S4), the first metallization being in contact with the anodes (42-1) of the vertical diodes and the layers of cathodes (44) of the Shockley diodes, and wherein the third well comprises, on his front face side, two lateral diodes, each of which is formed between a P-type region (52, 53) and the substrate,
**characterized in that** the third well is separated from the first metallization by a P-type insulating layer (61) extending on its rear surface side in contact with the first metallization.

2. A semiconducting structure according to claim 1, **characterized in that** the anode layers (42-1) of the rear surface side of the vertical diodes of the first and second wells are comprised of a deep diffused layer similar to an insulating wall diffusion.

3. A semiconducting structure according to claim 1 or 2, **characterized in that** the anode layers (40-1, 40-2) of each of the Shockley diodes are comprised of a central portion (40-2) formed by a diffusion similar to an insulating wall diffusion and of a lateral portion (40-1) formed by a P-type diffusion which is shallower and more doped in surface.

4. A semiconducting structure according to any of claims 1 to 3, **characterized in that** each of the insulating walls comprises an overdoped region of the same type of conductivity (63), coated on most of its surface with a metallization (65).

5. A semiconducting structure according to claim 1, **characterized in that** the anode layers (52, 53) of the lateral diodes and the P-type insulating layer (61) are shallow and highly-doped layers.

## Patentansprüche

1. Halbleiterstruktur, welche eine geschützte Gleichrichtbrücke bildet, die in einem Halbleitersubstrat (1) vom N-Leitfähigkeitstyp realisiert ist, das durch vertikale Isolierwandungen (30,31) vom P-Typ in drei Gräben bzw Schächte unterteilt ist, und in welcher die Rück-bzw. Unterseite des Substrats mit einer ersten Metallisierung (T-) überzogen ist, in welcher jeweils der erste und der zweite Graben bzw Schacht eine vertikale Diode (D2, D4) und eine vertikale Shockley- Diode (S2, S4) aufweist, die erste Metallisierung mit den Anodenschichten (42-1) der vertikalen Dioden und mit den Kathodenschichten (44) der Shockley-Dioden in Kontakt steht, und in welcher der dritte Graben bzw Schacht auf seiner Vorder- bzw Oberseite zwei laterale Dioden aufweist, deren jede jeweils zwischen einem Bereich (52, 53) vom P-Leitfähigkeitstyp und dem Substrat ausgebildet ist, **dadurch gekennzeichnet, dass** der dritte Graben bzw Schacht von der ersten Metallisierung durch eine Isolierschicht (61) vom P-Iyp getrennt ist, die sich auf seiner Rück-bzw. Unterseite in Kontakt mit der ersten Metallisierung erstreckt.

2. Halbleiterstruktur nach Anspruch 1, **dadurch gekennzeichnet, dass** die Anadenschichten (42-1) auf der Rück-bzw. Unterseite der vertikalen Dioden des ersten und des zweiten Grabens bzw Schachts von einem tiefen Diffusionsbereich gebildet werden, ähnlich einer Diffusion einer Isolierwandung

3. Halbleiterstruktur nach einem der Ansprüche 1 oder 2, **dadurch gekennzeichnet dass** die Anodenschichten (40-1, 40-2) jeder der Shockley-Dioden aus einem mittleren Teil (40-2), der durch eine Diffusion ähnlich einer Diffusion einer Isolierwandung ausgebildet wurde, und aus einem seitlichen Teil (40-1) besteht, die durch eine weniger tiefe und mehr an der Oberfläche dotierte Diffusion vpm P-Iyp gebildet wurde.

4. Halbleiter Struktur nach einem der Ansprüche 1 bis 3, **dadurch gekennzeichnet, dass** jede der Isolierwandungen einen überdotierten Bereich vom selben Leitfähigkeitstyp (63) aufweist, der auf dem größten Teil seiner Oberfläche mit einer Metallisierung (65) überzogern ist

5. Halbleiterstruktur, nach Anspruch 1, **dadurch gekennzeichnet, dass** die Anoden schichten (52, 53) der lateralen Dioden und die genannte Isolierschicht (61) vom P-Iyp Schichten geringer Tiefe und stark dotierte Schichten sind
